(19) Europäisches Patentamt
European Patent Office
Office européen des brevets

(11) **EP 4 195 901 A1**

(12) **EUROPEAN PATENT APPLICATION**

(43) Date of publication:
**14.06.2023 Bulletin 2023/24**

(21) Application number: **22211089.2**

(22) Date of filing: **02.12.2022**

(51) International Patent Classification (IPC):
**H10K 59/124** (2023.01)    **H10K 59/80** (2023.01)

(52) Cooperative Patent Classification (CPC):
**H10K 59/876; H10K 59/124; H10K 59/80515; H10K 59/879**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **13.12.2021 JP 2021201991**
**05.08.2022 JP 2022125852**
**17.11.2022 JP 2022184315**

(71) Applicant: **CANON KABUSHIKI KAISHA**
**Tokyo 146-8501 (JP)**

(72) Inventors:
• **ITO, Takayuki**
**Tokyo (JP)**
• **KAJIMOTO, Norifumi**
**Tokyo (JP)**
• **SANO, Hiroaki**
**Tokyo (JP)**
• **KANEDA, Tasuku**
**Tokyo (JP)**
• **MATSUDA, Yojiro**
**Tokyo (JP)**
• **OKITA, Akira**
**Tokyo (JP)**

(74) Representative: **WESER & Kollegen**
**Patentanwälte PartmbB**
**Radeckestraße 43**
**81245 München (DE)**

(54) **LIGHT EMITTING DEVICE, DISPLAY DEVICE, IMAGE SENSING DEVICE, AND ELECTRONIC APPARATUS**

(57)    A light emitting device in which a reflective film, a first electrode, an organic film including a light emitting layer, a second electrode, and an optical member are arranged in this order on a principal surface of a substrate and a bank configured to cover a peripheral portion of the first electrode is provided to define a light emitting region. The reflective film, the first electrode, the organic film, and the second electrode form a resonator structure configured to resonate, between the reflective film and the second electrode, light generated in the organic film. In the light emitting region, an upper surface of the reflective film is flatter than the first electrode. The resonator structure has a plurality of different optical path lengths.

**FIG. 3**

**Description**

BACKGROUND OF THE INVENTION

Field of the Invention

The present invention relates to a light emitting device, a display device, an image sensing device, and an electronic apparatus.

Description of the Related Art

In recent years, an organic light emitting element (to also be called an organic EL element or OLED) usable as a light source has been developed. In a display device using an organic light emitting element as a light source, sub-pixels of red (R), green (G), and blue (B) are provided to implement full-color display. Since the organic light emitting element uses the light emitting phenomenon of organic light emitting molecules, it generally emits light with a wide spectrum specific to an organic material. This causes a problem that color purity lowers to narrow the color reproduction range of the display device. In addition, since most of light generated in an organic light emitting element is confined in the organic light emitting element, actually extracted light is reduced. To improve the color purity and light extraction efficiency, there is provided, for example, a method using a microresonator structure and a lens, as described in Japanese Patent Laid-Open No. 2011-54526.

Light emitted from an organic light emitting element having a microresonator structure has a spectral line width that narrows in accordance with the wavelength range within which the light resonates in the resonator. Therefore, while the organic light emitting element having the microresonator structure is advantageous in improving the color purity, the spectral line width narrows due to the resonance effect and thus the amount of extracted light decreases to lower luminance.

To solve this problem, if an optical member such as a microlens is used on the organic light emitting element having the microresonator structure to improve luminance, oblique light deviating from the normal direction of the above-described resonator structure is also externally extracted by the optical member. However, light strengthened by the resonator effect other than light of a desired wavelength is extracted, thereby lowering the color purity.

SUMMARY OF THE INVENTION

The present invention provides a technique advantageous in efficiently extracting light of a desired wavelength without lowering color purity.

The present invention in its first aspect provides a light emitting device as specified in claims 1 to 9 and 30.

The present invention in its second aspect provides a light emitting device as specified in claims 10 to 30.

The present invention in its third aspect provides a display device as specified in claim 31.

The present invention in its forth aspect provides an image sensing device as specified in claim 32.

The present invention in its fifth aspect provides an electronic apparatus as specified in claim 33.

Further features of the present invention will become apparent from the following description of exemplary embodiments with reference to the attached drawings.

BRIEF DESCRIPTION OF THE DRAWINGS

Fig. 1 is a schematic plan view showing the arrangement of a light emitting device according to the first embodiment;
Fig. 2 is a plan view of a region surrounded by a broken line in Fig. 1;
Fig. 3 is a schematic sectional view taken along a line A - A' in Fig. 2;
Fig. 4A is a schematic sectional view of a sub-pixel of the light emitting device according to the first embodiment;
Fig. 4B is a schematic sectional view of a sub-pixel of the light emitting device according to the first embodiment;
Fig. 5 is a schematic sectional view of a sub-pixel of the light emitting device according to the first embodiment;
Fig. 6 is a schematic sectional view of a sub-pixel of a light emitting device according to the second embodiment;
Fig. 7 is a schematic sectional view of a sub-pixel of a light emitting device according to the third embodiment;
Fig. 8 is a schematic sectional view of a sub-pixel of a light emitting device according to the fourth embodiment;
Fig. 9 is a schematic sectional view of a sub-pixel of a light emitting device according to the fifth embodiment;
Fig. 10 is a schematic sectional view of the sub-pixel of the light emitting device according to the fifth embodiment;
Figs. 11A to 11F are schematic plan views each showing the sub-pixel of the light emitting device according to the fifth embodiment;

Fig. 12A is a view for explaining interference according to a comparative example;
Fig. 12B is a view for explaining interference according to the first embodiment;
Fig. 13 is a schematic sectional view of the light emitting device according to the first embodiment;
Figs. 14A and 14B are a schematic plan view and a schematic sectional view of a light emitting device according to another embodiment;
Fig. 15 is a view for explaining a method of manufacturing the light emitting device according to the first embodiment;
Fig. 16 is a view for explaining the method of manufacturing the light emitting device according to the first embodiment;
Fig. 17 is a view for explaining the method of manufacturing the light emitting device according to the first embodiment;
Fig. 18 is a view for explaining the method of manufacturing the light emitting device according to the first embodiment;
Fig. 19 is a view for explaining an application example;
Fig. 20 is a view for explaining an application example;
Fig. 21A is a view for explaining an application example;
Fig. 21B is a view for explaining an application example;
Fig. 22A is a view for explaining an application example; and
Fig. 22B is a view for explaining an application example.

DESCRIPTION OF THE EMBODIMENTS

Hereinafter, embodiments will be described in detail with reference to the attached drawings. Note, the following embodiments are not intended to limit the scope of the claimed invention. Multiple features are described in the embodiments, but limitation is not made to an invention that requires all such features, and multiple such features may be combined as appropriate. Furthermore, in the attached drawings, the same reference numerals are given to the same or similar configurations, and redundant description thereof is omitted.

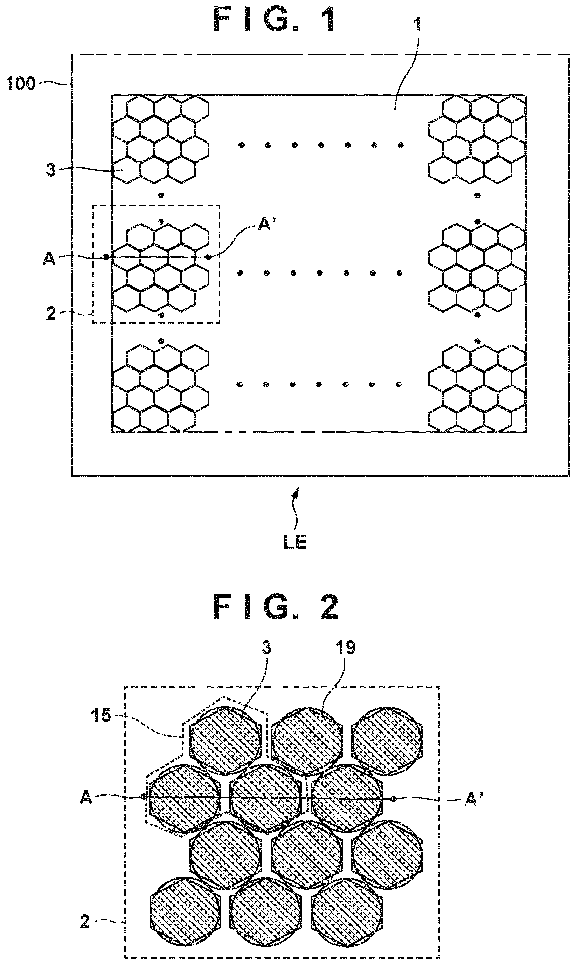

Fig. 1 is a plan view of a light emitting device LE according to the first embodiment. The plan view shows a planar view. The light emitting device LE can be formed as a display device having a display region 1 formed by a plurality of sub-pixels 3 arrayed on the principal surface of a substrate 100. The plurality of sub-pixels 3 can be classified into a plurality of groups depending on light emission colors. Fig. 1 shows an example in which the plurality of sub-pixels 3 are arranged in a delta array but the plurality of sub-pixels 3 may be arranged in another array such as a stripe array, a square array, a pentile array, or a Bayer array.

Fig. 2 is an enlarged view of a partial region 2 shown in Fig. 1. One pixel 15 is formed by the plurality of sub-pixels 3 that emit different light emission colors. One pixel 15 can be formed by, for example, a sub-pixel 3R that generates red (R) light, a sub-pixel 3G that generates green (G) light, and a sub-pixel 3B that generates blue (B) light. When explaining the sub-pixels 3R, 3G, and 3B without distinction, these will be expressed as a sub-pixel 3 hereinafter. Each sub-pixel 3 can further include an optical member 19 for collimating light emitted from the light emitting region of each sub-pixel 3 and externally emitting the light. Referring to Fig. 2, in a plan view, that is, a planar view from a direction perpendicular to the principal surface of the substrate 100, the center of the light emitting region almost coincides with the center of the optical member 19.

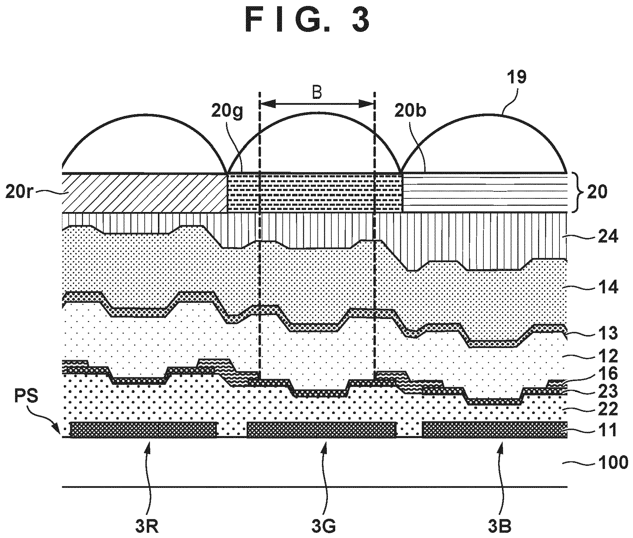

Fig. 3 is a schematic sectional view taken along a line A - A' in Figs. 1 and 2. The A - A' plane is a plane that crosses the three sub-pixels 3 (3R, 3G, and 3B) with different light emission colors. A light emitting region B of each sub-pixel 3 is defined by the opening of a bank 16. The bank 16 covers the peripheral portion of a first electrode 23 to expose the light emitting region B. The shape of the light emitting region B is arbitrary, and may be, for example, a circular or elliptic shape, a polygonal shape such as a hexagonal shape or rectangular shape, or another shape. Alternatively, by arranging openings of the bank 16 to assign a plurality of openings to one sub-pixel 3, a plurality of light emitting regions may be provided in one sub-pixel. If the light emitting region has a polygonal shape, for example, the center of the inscribed circle of the polygon can be understood as the center of the light emitting region. If the light emitting region B has a circular or elliptic shape, the center of the circle or ellipse can be understood as the center of the light emitting region.

Each sub-pixel 3 is a light emitting element obtained by arranging a reflective film 11, a transparent insulating film 22, the first electrode 23, an organic film 12 including a light emitting film, a second electrode 13, a sealing film 14, and the optical member 19 on a principal surface PS of the substrate 100 in this order. The bank 16 covering the peripheral portion of the first electrode 23 is provided to define the light emitting region B. The bank 16 includes an opening to expose the first electrode 23, and this opening defines the light emitting region B. A color filter layer 20 can be arranged on the sealing film 14. Furthermore, a planarizing film 24 may be arranged between the sealing film 14 and the color filter layer 20. In the substrate 100, a driving circuit including a transistor for deriving the sub-pixel 3 (light emitting element) can be arranged.

The reflective film 11 can be made of a metal with a high reflectance such as Al, Ag, Ti, Mo, or W or an alloy thereof. The reflective film 11 can include a flat upper surface (reflective surface) in the light emitting region B. The upper surface of the reflective film 11 is almost parallel to the principal surface PS (or the approximate plane of the principal surface PS) of the substrate 100 in the light emitting region B. The upper surface of the reflective film 11 may have surface roughness of about several nm as long as an appropriate reflectance can be achieved. From a given viewpoint, the upper surface of the reflective film 11 may be flatter than the first electrode 23 (for example, the upper surface of the first electrode 23) in the light emitting region B. From another viewpoint, the upper surface of the reflective film 11 may be flatter than the second electrode 13 (for example, the upper surface of the second electrode 13) in the light emitting region B. From still another viewpoint, the upper surface of the reflective film 11 may be flatter than the upper surface of the transparent insulating film 22 in the light emitting region B. As the surface is flatter, a numerical value representing flatness is smaller. The flatness can be evaluated as the difference between the maximum value and the minimum value of the deviation quantity of an evaluation target surface (in this example, the upper surface of the reflective film 11) from a reference plane. If the entire evaluation target surface exists on one side of the reference plane and the evaluation target surface is partially in contact with the reference plane, the flatness can be evaluated as the maximum value of the deviation quantity of the evaluation target surface from the reference plane. In addition, "flat" can be interpreted as "no step". For example, referring to Fig. 3, the first electrode includes a step but the reflective film includes no step.

The stacked structure of the first electrode 23, the organic film 12, and the second electrode 13 forms an organic light emitting element or a light emitting element. The organic film 12 can include a charge transport layer in addition to a light emitting layer. The light emitting layer can contain a light emitting material. By applying a voltage between the first electrode 23 and the second electrode 13, charges can be injected into the organic film 12. The injected charges are recombined in the light emitting layer, and a fluorescent substance in the light emitting layer emits light, thereby externally emitting light. A known material can be used as the material of the charge transport layer in the organic film 12 and the material of the fluorescent substance. The light emitting material may be a fluorescent substance or phosphorescent substance, or may contain a plurality of materials. In one example, the light emitting layer is configured to generate almost white light. For example, the light emitting layer is formed by a plurality of layers, and each layer can contain a red, green, or blue fluorescent substance. The reflective film 11, the transparent insulating film 22, the first electrode 23, the organic film 12, and the second electrode 13 form a resonator structure for resonating, between the reflective film 11 and the second electrode 13, light generated in the organic film 12. The transparent insulating film 22 has a thickness (maximum thickness or average thickness) different for each of the sub-pixels 3R, 3G, and 3B. The transparent insulating film 22 can be made of, for example, an inorganic material such as $SiO_2$ or SiN or a transparent resin such as polyimide. Furthermore, the bank 16 can be made of, for example, an inorganic material such as $SiO_2$ or SiN or a transparent resin such as polyimide.

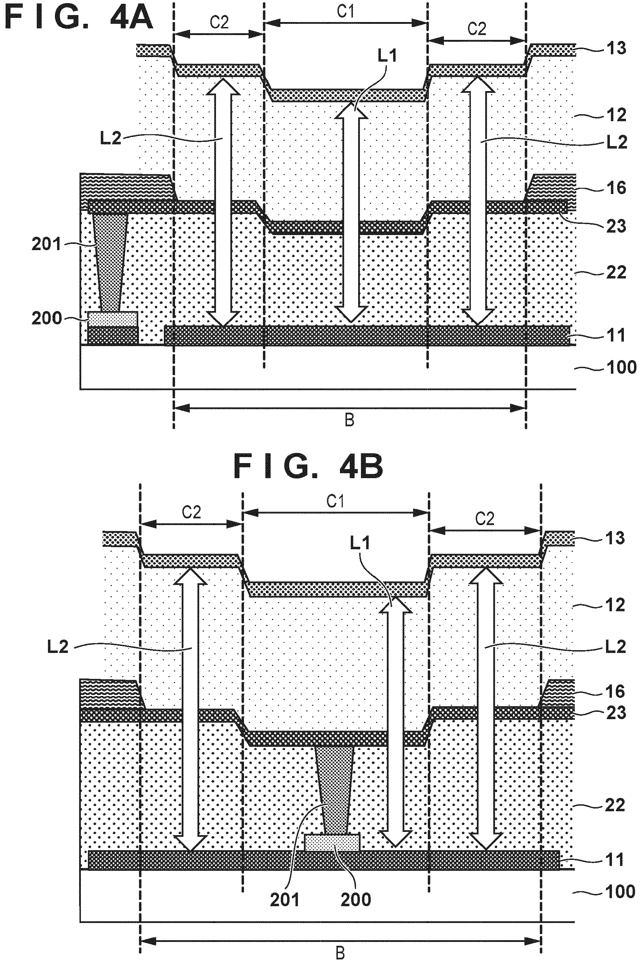

Fig. 4A representatively shows the reflective film 11, the transparent insulating film 22, the first electrode 23, the organic film 12, and the second electrode 13 of one of the three kinds of sub-pixels 3 shown in Fig. 3. The resonator structure of each sub-pixel 3 can be configured to have a plurality of different optical path lengths. For example, the reflective film 11, the transparent insulating film 22, the first electrode 23, the organic film 12, and the second electrode 13 can be arranged to define a plurality of different optical path lengths. The plurality of different optical path lengths in one sub-pixel 3 can be implemented by, for example, forming the second electrode 13 to have at least one step (or a plurality of steps) in the light emitting region B defined by the bank 16.

At least one step of the second electrode 13 (the lower or upper surface thereof) can be implemented by forming at least one step in the transparent insulating film 22 (the upper surface thereof). More specifically, by forming at least one step in the transparent insulating film 22 (the upper surface thereof), at least one step can be formed in the first electrode 23 (the upper surface thereof) to follow at least one step of the transparent insulating film 22. Similarly, at least one step can be formed in the organic film 12 (the upper surface thereof) to follow at least one step of the first electrode 23 (the upper surface thereof). Similarly, at least one step can be formed in the second electrode 13 (the lower or upper surface thereof) to follow at least one step of the organic film 12 (the upper surface thereof). That is, by forming at least one step in the transparent insulating film 22, at least one step can be formed in the second electrode 13 (the lower or upper surface thereof) to follow at least one step of the transparent insulating film 22.

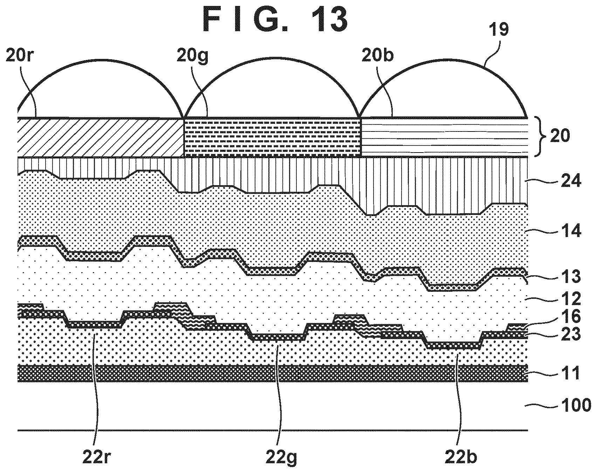

The first electrode 23 is preferably made of a material having high transmittance of light (particularly, visible light). The first electrode 23 can be made of, for example, ITO, IZO, or IGZO as a transparent oxide conductor. The first electrode 23 can be formed by a sputtering method, a CVD method, or the like. Furthermore, the first electrode 23 can electrically be connected to the circuit of the substrate 100 via contact portions 201 and 200. The contact portions 201 and 200 can be made of, for example, W, Ti, TiN, or the like. Instead of the contact portions 201 and 200, a contact portion may be provided in the reflective film 11 to serve as a reflective film and an electrode. As exemplified in Fig. 13, the reflective film 11 may commonly be provided for two or more pixels or all the pixels.

The organic film 12 can be formed by a known deposition method such as a vacuum deposition method, an inkjet method, or a spin coating method. In particular, a vacuum deposition method that readily forms a film to follow the step of the underlying layer (the first electrode 23 and the bank 16) is preferably adopted. However, as long as a film is formed to follow the step of the underlying layer, a deposition method other than the vacuum deposition method may be used to form a film. In the light emitting region B, the second electrode 13 can include a first region C1 corresponding to an optical path length L1 and a second region C2 corresponding to an optical path length L2. The second region C2 is a region outside the first region C1. The first region C1 can be a region including a central portion of the second electrode 13 in a planar view. The optical path length L2 is longer than the optical path length L1. Note that the second electrode 13 includes the first region C1 and the second region C2 in this example, but it may be understood that the light emitting region B includes the first region C1 and the second region C2. Alternatively, it may be understood that the first electrode 23 includes the first region C1 and the second region C2.

The contact portions 201 and 200 can be arranged outside the second region C2, as exemplified in Fig. 4A, in a plan view, that is, a planar view from a direction perpendicular to the principal surface of the substrate 100. Alternatively, the contact portions 201 and 200 can be arranged in the first region C1, as exemplified in Fig. 4B, in a plan view, that is, a planar view from a direction perpendicular to the principal surface of the substrate 100. Alternatively, the contact portions 201 and 200 can be arranged in the second region C2 in a plan view, that is, a planar view from a direction perpendicular to the principal surface of the substrate 100.

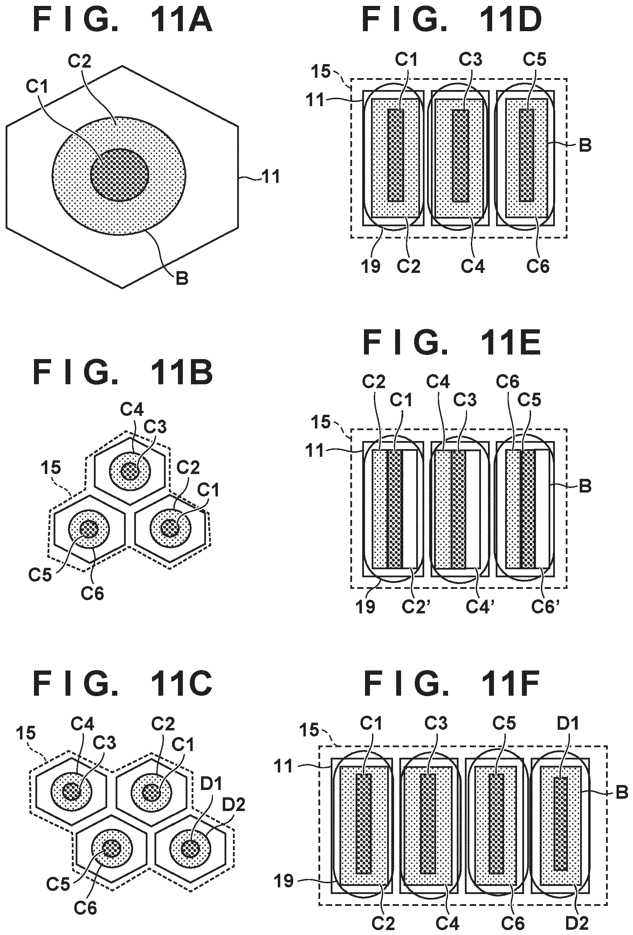

Fig. 11A exemplifies a plan view (planar view) of the sub-pixel 3 exemplified in Figs. 4A and 4B. Fig. 11B shows an example in which a resonator structure including a plurality of regions for implementing a plurality of different optical path lengths in a light emitting region is provided in each of all the R, G, and B sub-pixels 3 forming the pixel 15. In one sub-pixel, the first region C1 defines an optical path length that strengthens a desired wavelength suitable to the light emission color of the sub-pixel, and the second region C2 defines an optical path length longer than that defined by the first region C1. Furthermore, in another sub-pixel, a first region C3 defines an optical path length that strengthens a desired wavelength suitable to the light emission color of the sub-pixel, and a second region C4 defines an optical path length longer than that defined by the first region C3. In still another sub-pixel, a first region C5 provides an optical path length that strengthens a desired wavelength suitable to the light emission color of the sub-pixel, and a second region C6 provides an optical path length longer than that provided by the first region C5. The second regions C2, C4, and C6 are regions outside the first regions C1, C3, and C5, respectively. In any of the sub-pixels, the second region arranged outside defines an optical path length longer than that defined by the first region arranged inside. As exemplified in Figs. 11A and 11B, the first region arranged inside can have a circular shape, and the second region arranged outside can have a ring shape surrounding the first region. Alternatively, the first region arranged inside can have an elliptic shape, and the second region arranged outside can have an elliptic ring shape surrounding the first region. Alternatively, as exemplified in Fig. 11D, the first region arranged inside can have a rectangular shape, and the second region arranged outside can have a frame shape surrounding the first region.

The sealing film 14 can be made of, for example, SiN, SiON, or SiOx. The sealing film 14 can be formed by, for example, the CVD method. The sealing film 14 may be formed by a multilayer film including at least one layer of, for example, an ALD (atomic deposition layer) and a resin film in addition to the SiN film or SiON film. The planarizing film 24 can be arranged on the sealing film 14. By providing the planarizing film 24, the color filter layer 20 and the optical member 19 arranged on the sealing film 14 can be formed more stably. The planarizing film 24 can be formed by forming a transparent resin by a coating method. Alternatively, the planarizing film 24 may be formed by forming a film of a transparent inorganic material and planarizing it by a CMP (chemical mechanical polishing) method or the like. The color filter layer 20 matching the light emission color of each sub-pixel can be arranged on the planarizing film 24. The color filter layer 20 can be made of a known material, and can be provided to further improve the color purity emitted from the light emitting device LE. The color filter layer 20 includes color filters 20r, 20g, and 20b in accordance with the respective sub-pixels. The thicknesses of the color filters 20r, 20g, and 20b are made almost equal to each other, thereby making it possible to form the optical member 19 on the color filter layer 20 more stably.

The optical member 19 can be a collimator for collimating light emitted from the light emitting region of each sub-pixel 3 and externally emitting the light. The optical member 19 can be provided for each sub-pixel 3. The optical member 19 can be a lens or microlens having a surface (for example, a spherical surface) in contact with the air. The microlens as the optical member 19 may be made of, for example, a resin such as acrylic resin or epoxy resin, or an inorganic material such as SiN or SiO. By providing the optical member 19, it is possible to increase the amount of light externally extracted from the light emitting element, and control the direction of the extracted light. If the microlens as the optical member 19 has a hemispherical shape, the contact between the microlens and a tangent parallel to the upper surface of the planarizing film 24 among tangents in contact with the hemisphere serves as the vertex of the microlens. The vertex of the microlens can be decided in the same manner even in an arbitrary sectional view. That is, the contact between the microlens and the tangent parallel to the upper surface of the planarizing film 24 among the tangents in contact with the surface of the microlens in a sectional view serves as the vertex of the microlens.

The shape of the microlens can be controlled by adjusting the exposure and developing process. More specifically, a photoresist film is formed, exposed using a photomask including a continuous change in gradation, and then developed. As the photomask, a gray mask or an area gradation mask can be used. The area gradation mask forms a light intensity distribution having continuous gradations on the imaging plane by changing the density distribution of dots formed from a light shielding film with a resolution smaller than the resolution of an exposure apparatus. The lens shape may be adjusted by etching back the microlens obtained by the exposure and developing process. The shape of the microlens need only have a curved surface that can refract radiation light, and may have a spherical or aspherical surface or an asymmetrical sectional shape.

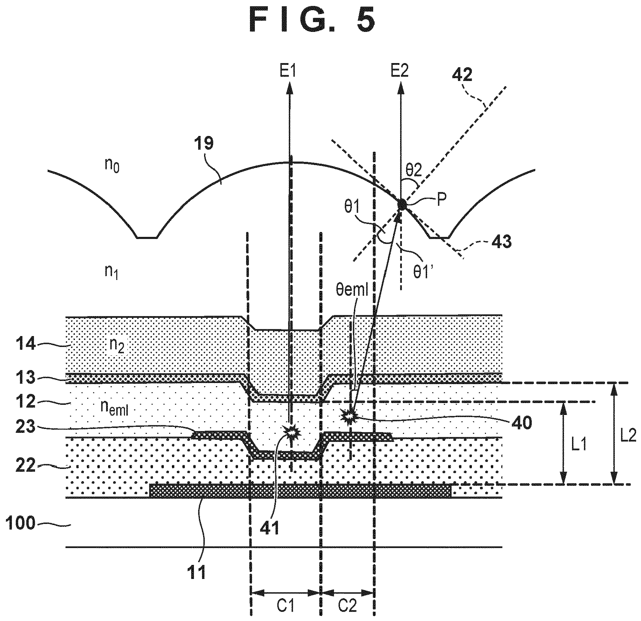

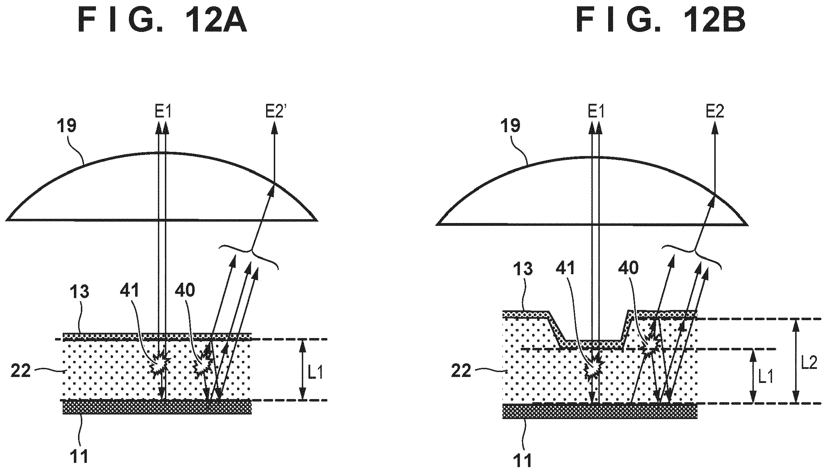

The resonator structure will be described next with reference to Figs. 5, 12A, and 12B. As exemplified in Fig. 5, the light emitting element forming the sub-pixel forms the resonator (interferometer) structure having characteristics different for the central region C1 and the outer region C2 of the second electrode 13 (or the light emitting region). The optical path length L2 in the outer region C2 is longer than the optical path length L1 in the central region C1. Fig. 12A shows the resonator structure according to a comparative example. Fig. 12B schematically shows the resonator structure according to this embodiment. As shown in Fig. 12A or 12B, a light beam E2' or E2 collimated from the end portion of the optical member 19 to the front direction (substrate normal direction) among light beams entering the optical member 19 is a light beam emitted in an oblique direction from the end portion of the light emitting region. This is because the optical member 19 is in contact with the air (refractive index $n_0 = 1$) and the optical member 19 (refractive index $n_1 > 1$) is a convex lens. For the sake of simplicity, each of Figs. 12A and 12B shows the reflective film 11 and the second electrode 13 of the light emitting element. The transparent insulating film 22, the first electrode 23, and the organic film 12 are arranged between the reflective film 11 and the second electrode 13, and serve as media in the optical path. Reference numeral 41 denotes a light emitting point near the center of the light emitting element; and 40, a light emitting point at an outer position. In each of Figs. 12A and 12B, in interference design at the light emitting point 41, the optical path length L1 can be determined so as to strengthen a light beam of a desired wavelength in a light beam E1 emitted in the substrate normal direction (the normal direction of the principal surface PS of the substrate 100) from the optical member 19. If $\lambda 1$ represents a wavelength (resonant wavelength) resonated by the resonator structure, the optical path length can be set in accordance with:

$$L * \cos(\theta_{eml}) = (2m - \Phi/\pi) \times (\lambda/4) \qquad \qquad ...(1)$$

where m represents an integer of 0 or more, $\Phi$ represents the sum of phase shifts when a light beam of a wavelength $\lambda$ is reflected by the upper surface of the reflective film 11 and the lower surface of the second electrode 13 (defined as a negative value), and $\theta_{eml}$ represents a radiation angle of a light beam emitted from the light emitting point with respect to the substrate normal.

Therefore, if the light beam E1 is a light beam of the desired wavelength $\lambda 1$, L1 is set to satisfy:

$$L1 = (2m - \Phi/\pi) \times (\lambda 1/4), (\theta_{eml} = 0) \qquad \qquad ...(2)$$

By modifying this equation, equation (3) below is obtained:

$$\lambda 1 = 4/(2m - \Phi/\pi)) \times L1 \qquad \qquad ...(3)$$

On the other hand, under this condition, with respect to the light beam E2' in Fig. 12A, a light beam of $\theta_{eml} > 0$ is emitted, and equation (4) below is thus obtained from equation (1):

$$L1 \times \cos(\theta_{eml}) = (2m - \Phi/\pi) \times (\lambda/4) \qquad \qquad ...(4)$$

By modifying equation (4), equation (5) below is obtained:

$$\lambda = (4/(2m - \Phi/\pi)) \times L1 \times \cos(\theta_{eml}) \qquad \qquad ...(5)$$

Since $\cos(\theta_{eml}) < 1$, it is understood from equation (3) that $\lambda$ of the emitted light beam E2' is smaller than $\lambda 1$.

Therefore, light beams extracted in the substrate normal direction in Fig. 12A are the light beams E1 and E2'. If it is designed to extract the light beam E1 as a desired light beam, a light beam such as the light beam E2' other than the light beam of the desired wavelength is extracted. Thus, in the comparative example shown in Fig. 12A, the color purity of observed light emission color lowers, thereby making it impossible to efficiently extract the light beam of the desired wavelength.

To the contrary, in Fig. 12B according to this embodiment, the light beam E2 is a light beam from a region of L2 > L1. It is possible to set the resonant wavelength of a light beam emitted at an angle of $\theta_{eml}$ to $\lambda 1$, by setting L2 so as to satisfy:

$$L2 \times \cos(\theta_{eml}) = (2m - \Phi/\pi) \times (\lambda1/4) \qquad ...(6)$$

Therefore, light beams extracted in the arrangement shown in Fig. 12B according to this embodiment are the light beams E1 and E2 of $\lambda$1, thereby making it possible to efficiently extract the light beam of the desired wavelength $\lambda$1 without lowering the color purity.

As shown in Fig. 5, the light beam E2 is emitted from a point P of the optical member 19. A perpendicular 42 passing through the point P on a tangent 43 in contact with the point P can be considered. The light beam E2 forms an angle $\theta$2 with the perpendicular 42. Similarly, an angle $\theta$1 formed by a light beam entering the point P from the light emitting element can be derived. In addition, an angle $\theta$1' formed by the light beam E2 and the light beam entering the point P from the light emitting element is obtained. Finally, the radiation angle $\theta_{eml}$ of the light emitting element to obtain the light beam E2 is derived by the Snell's law, and $\theta_{eml}$ can be expected by:

$$n_1 \times \sin(\theta1') = n_{eml} \times \sin(\theta_{eml}) \qquad ...(7)$$

where $n_1$ represents the refractive index of the optical member 19 and $n_{eml}$ represents the refractive index of the light emitting layer.

When $n_{eml} = 1.8$ and $n_1 = 1.5$, $\theta_{eml}$ to obtain the light beam E2 emitted from the point P is 10° to 30°.

Therefore, if $\theta_{eml} = 10°$ to 30°, equation (8) below is obtained from equations (2) and (6) to resonate the same resonant wavelength $\lambda$1 as that when $\theta_{eml} = 0°$.

$$L2 = L1/\cos(\theta_{eml}) \qquad ...(8)$$

Therefore, if $\Delta L = L2 - L1$, $\Delta L$ is roughly given by $(0.015$ to $0.15) \times L1$.

For example, if $\lambda1 = 530$ nm and $m = 1$, the optical path length L1 is almost equal to the wavelength $\lambda$1. Thus, if the refractive index for the optical path length L1 is about 1.8, the physical film thickness is about 294 nm. Therefore, the film thickness of the transparent insulating film 22 is set so that $\Delta L$ falls within the range of 4 nm (inclusive) to 44 nm (inclusive).

Similarly, if $\lambda1 = 450$ nm and $m = 1$, $\Delta L$ falls within the range of 3.8 nm (inclusive) to 38 nm (inclusive). If $\lambda1 = 630$ nm and $m = 1$, $\Delta L$ falls within the range of 5.3 nm (inclusive) to 53 nm (inclusive). More specifically, since $\Delta L$ can change depending on the dispersion of refractive indices of the respective films, the optical path lengths L1 and L2 can be set in accordance with the desired wavelength by setting the physical film thickness of the transparent insulating film 22 in consideration of the refractive index of each film. Furthermore, as long as $\Delta L$ falls within the above range (4 nm (inclusive) to 53 nm (inclusive)), steps of the same thickness can be formed for the R, G, and B sub-pixels.

This embodiment is unnecessarily applied to all the R, G, and B sub-pixels forming the pixel 15, and may be applied to only one color such as only R, G, or B.

If the emission angle of light emitted from the organic light emitting element (sub-pixel 3) falls within a range of about 10° with respect to the substrate normal, the light has the same light characteristic as that of light emitted in the substrate normal direction (perpendicularly). Therefore, if the light is externally emitted from the optical member 19, the first region C1 preferably has an area falling within the range of 10% (inclusive) to 90% (inclusive) of the sum of the area of the first region C 1 and the area of the second region C2. This makes it possible to effectively emit the light of the first region C1 from the optical member 19, thereby suppressing lowering of the color purity and achieving high-efficiency light emission.

Furthermore, by adjusting the shape of the optical member 19, the second region C2 is made larger than the first region C1, and it is possible to efficiently, effectively extract light from the first region C1 (resonant wavelength region) and light obliquely emitted from the second region C2. In this case, the area of the first region C1 is preferably set to fall within the range of 10% (inclusive) to 50% (exclusive) of the sum of the area of the first region C1 and the area of the second region C2.

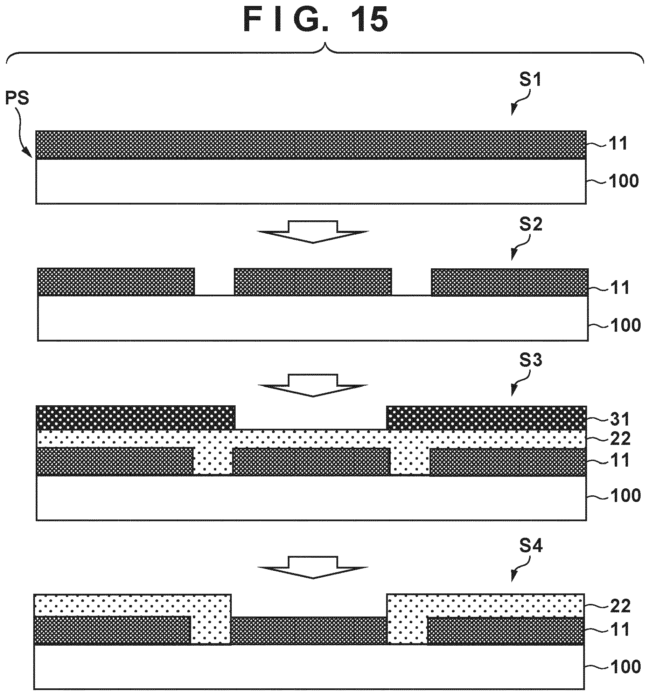

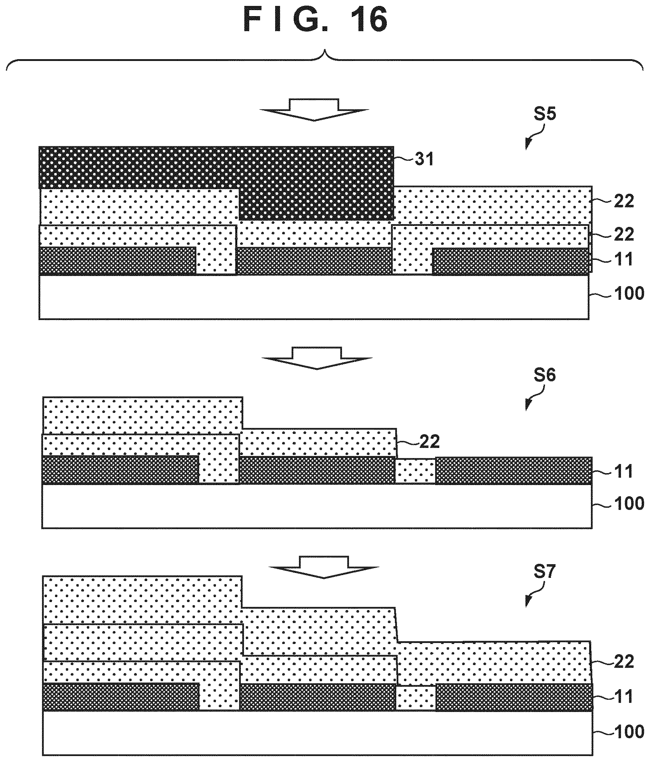

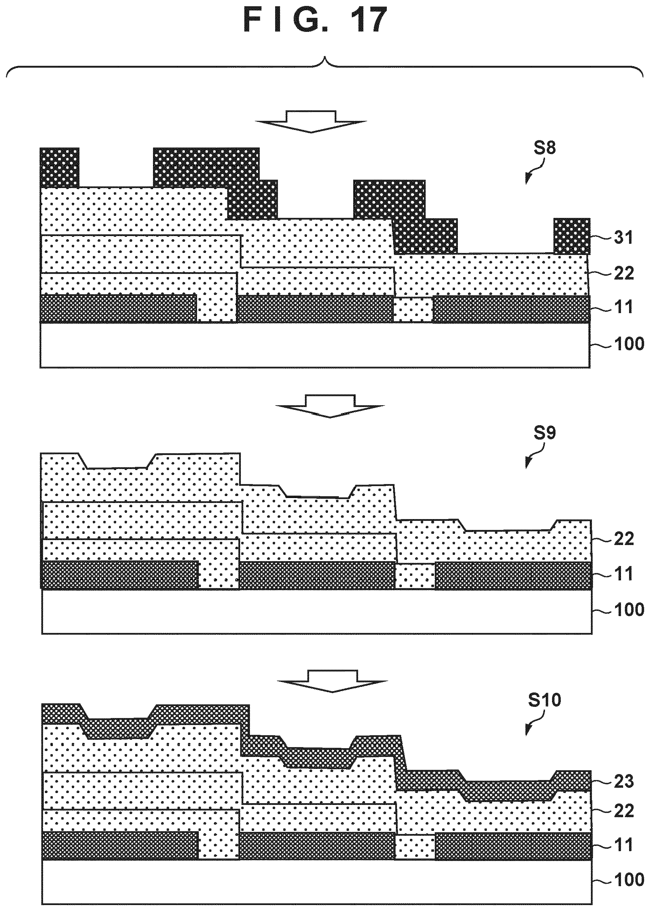

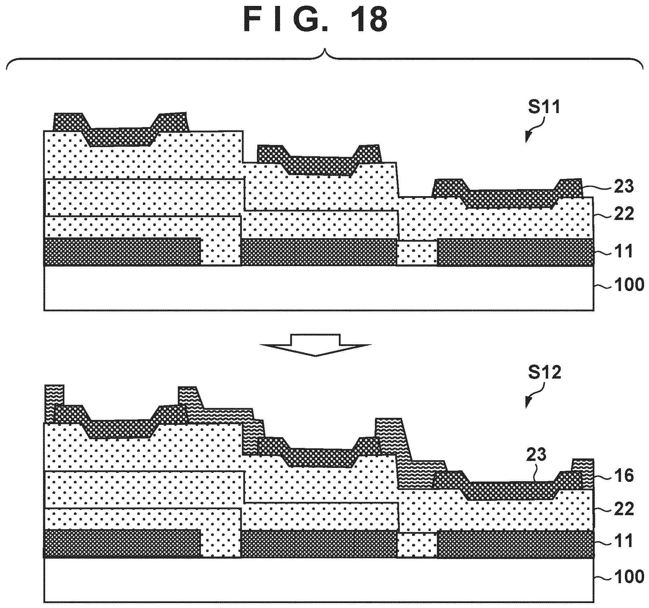

An overview of a method of manufacturing the light emitting device LE according to the first embodiment will be described below with reference to Figs. 15, 16, 17, and 18. In step S1, the substrate 100 on which the driving circuit has been formed is prepared, and a material film of the reflective film 11 is formed on the principal surface (upper surface) PS of the substrate 100. Next, in step S2, the material film of the reflective film 11 is patterned by a photolithography process to form the reflective film 11. In step S3, the transparent insulating film 22 is formed to cover the reflective film 11, and a photoresist film 31 is formed on it. In step S4, the photoresist film 31 is used as an etching mask to pattern the transparent insulating film 22 by dry etching.

Next, in step S5, the transparent insulating film 22 is further formed on the patterned transparent insulating film 22, and the photoresist film 31 is formed on it. In step S6, the photoresist film 31 is used as an etching mask to pattern the transparent insulating film 22 by dry etching. In step S7, the transparent insulating film 22 is further formed on the patterned transparent insulating film 22.

Next, in step S8, the photoresist film 31 is formed to process the transparent insulating film 22 so as to have a step in the light emitting region of each sub-pixel. In step S9, the photoresist film 31 is used as an etching mask to dry-etch the transparent insulating film 22. This forms the transparent insulating film 22 to have a step in the light emitting region of each sub-pixel. In step S10, the material film of the first electrode 23 is formed on the transparent insulating film 22 in which the steps have been formed.

In step S11, the material film of the first electrode 23 is patterned by a photolithography process to form the first electrode 23. The upper surface of the first electrode 23 has steps following the steps of the upper surface of the transparent insulating film 22. In step S12, the material film of the bank 16 is formed to cover the transparent insulating film 22 and the first electrode 23 and then patterned to form the bank 16.

After that, the organic film 12 including the light emitting layer, the second electrode 13, the sealing film 14, the planarizing film 24, the color filter layer 20, and the optical member 19 are sequentially formed on the first electrode 23 and the bank 16.

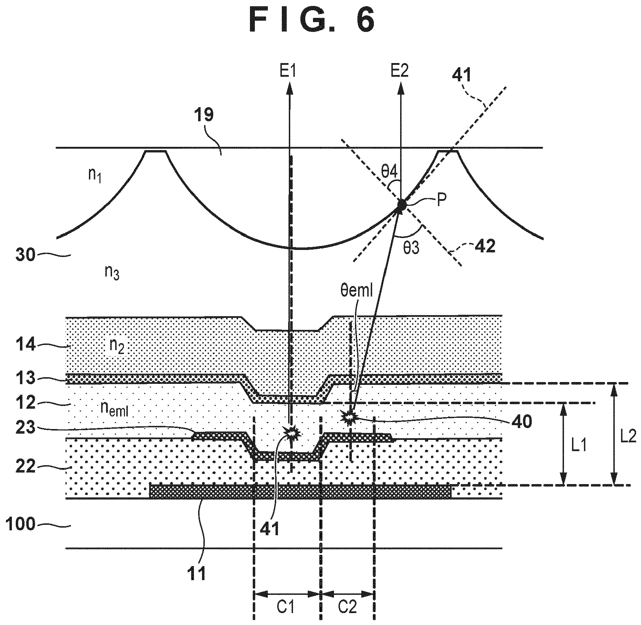

A light emitting device LE according to the second embodiment will be described below. Matters not mentioned in the second embodiment can comply with the first embodiment. Fig. 6 schematically shows the arrangement of the light emitting device according to the second embodiment. The light emitting device according to the second embodiment has an arrangement obtained by turning, upside down, an optical member 19 in the light emitting device of the first embodiment and arranging it on a sealing film 14 via a resin film 30. Note that a color filter layer 20 can be arranged between the sealing film 14 and the optical member 19. A refractive index $n_3$ of the resin film 30 is smaller than a refractive index $n_1$ of the optical member 19. Similar to the first embodiment, this arrangement can collimate light beams from light emitting points 40 and 41 of the light emitting element and cause them to be emitted from the light emitting device. Among light beams emitted from a light emitting region C2, a light beam E2 emitted at an angle of $\theta_{eml}$ can be extracted outside the light emitting device.

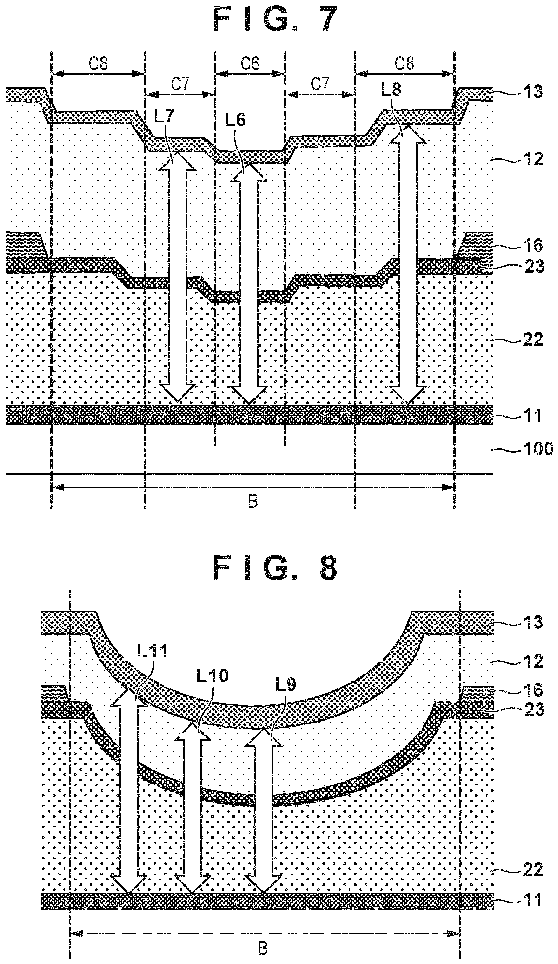

A light emitting device LE according to the third embodiment will be described below. Matters not mentioned in the third embodiment can comply with the first or second embodiment. In the third embodiment, the resonator structure of each sub-pixel 3 is configured to have three or more different optical path lengths. Fig. 7 schematically shows the arrangement of the light emitting device according to the third embodiment. A second electrode 13 (or a light emitting region B) of each sub-pixel can include a first region C6 corresponding to an optical path length L6, a second region C7 corresponding to an optical path length L7, and a third region C8 corresponding to an optical path length L8. The second region C7 is a region outside the first region C6, and the third region C8 is a region outside the second region C7. The optical path length L7 is longer than the optical path length L6, and the optical path length L8 is longer than the optical path length L7. The optical path lengths L6, L7, and L8 and the shape of an optical member 19 can be set in accordance with the wavelength of light extracted from the light emitting device and the like.

A light emitting device LE according to the fourth embodiment will be described below. Matters not mentioned in the fourth embodiment can comply with the first or second embodiment. Fig. 8 schematically shows the arrangement of the light emitting device according to the fourth embodiment. In the fourth embodiment, the resonator structure of each sub-pixel 3 is a structure in which an optical path length continuously changes. For example, a transparent insulating film 22 can have, as a curved surface or oblique surface, an upper surface having a concave lens surface shape.

A second electrode 13 (the lower or upper surface thereof) has an concave lens surface shape as a curved surface or oblique surface. The curved surface or oblique surface of the second electrode 13 (the lower or upper surface thereof) can be implemented by providing a curved surface or oblique surface on the transparent insulating film 22 (the upper surface thereof). More specifically, by providing a curved surface or oblique surface on the transparent insulating film 22 (the upper surface thereof), a curved surface or oblique surface can be formed on a first electrode 23 (the upper surface thereof) to follow the curved surface or oblique surface of the transparent insulating film 22. Similarly, a curved surface or oblique surface can be formed on an organic film 12 (the upper surface thereof) to follow the curved surface or oblique surface of the first electrode 23 (the upper surface thereof). Similarly, a curved surface or oblique surface can be formed on the second electrode 13 (the lower or upper surface) to follow the curved surface or oblique surface of the organic film 12 (the upper surface thereof). That is, by providing a curved surface or oblique surface on the transparent insulating film 22, a curved surface or oblique surface can be formed on the second electrode 13 (the lower or upper surface thereof) to follow the curved surface or oblique surface of the transparent insulating film 22.

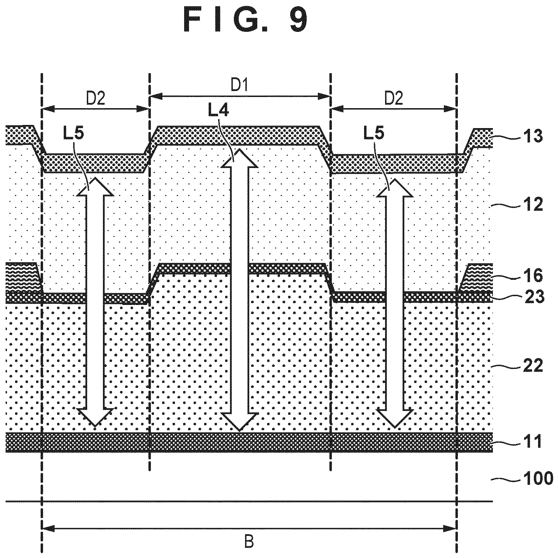

A light emitting device LE according to the fifth embodiment will be described below. Matters not mentioned in the fifth embodiment can comply with each of the first to fifth embodiments. Figs. 9, 10, 11C, and 11F schematically show the arrangement of the light emitting device according to the fifth embodiment. In the light emitting device according to the fifth embodiment, a pixel 15 can be formed by four or more sub-pixels. The pixel 15 can include, for example, a blue sub-pixel having light emitting regions C1 and C2, a green sub-pixel having light emitting regions C3 and C4, a red sub-pixel having light emitting regions C5 and C6, and a white sub-pixel having light emitting regions D1 and D2. The blue sub-pixel, the green sub-pixel, and the red sub-pixel can have, for example, the same arrangement as in each of the first and second embodiments. Each of the four sub-pixels may have a rectangular shape, as exemplified in Fig. 11F.

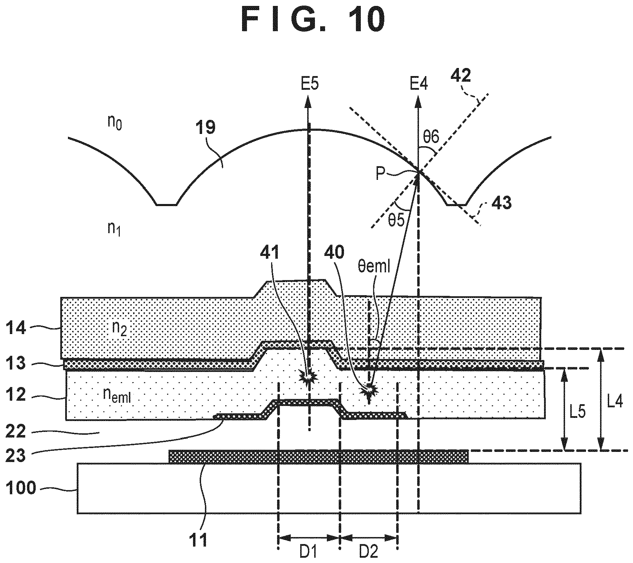

The white sub-pixel will be described with reference to Figs. 9 and 10. A second electrode 13 (or a light emitting region B) can include the first region D1 corresponding to an optical path length L4 and the second region D2 corresponding to an optical path length L5. The second region D2 is a region outside the first region D1. The optical path length L5 is shorter than the optical path length L4. In this arrangement, the wavelength of light extracted from the second region D2 is shorter than the wavelength of light extracted from the first region D1. Furthermore, as shown in Fig. 10, a light beam E4 emitted from a point P of an optical member 19 is a light beam obliquely emitted from a light emitting point 40 in the first region D2. Therefore, the wavelength of the light beam E4 extracted from the point P is shorter than the resonant wavelength of the first region D 1. If the light emitting element emits white light, it is possible to extract, from the first region D1, light of a yellow wavelength obtained by mixing the red to green wavelengths, and to extract light of a shorter blue wavelength from the second region D2. Therefore, it is possible to efficiently obtain desired white from the white sub-pixel using the complementary color relationship between yellow and blue.

If, for the optical path length L4, the resonant wavelength = 590 nm, m = 1, and the refractive index = 1.8, the physical film thickness for the optical path length L4 is about 328 nm. If, for the optical path length L5, the resonant wavelength $\lambda 2$ = 450 nm, equation (9) below can be obtained from equation (6):

$$L5 \times \cos(\theta_{eml}) = (2m - \Phi/\pi) \times (\lambda 2/4) \qquad ...(9)$$

If $\theta_{eml}$ is 10° to 30° and m = 1, the optical path length L5 falls within the range of about 380 nm (inclusive) to 445 nm (inclusive). Therefore, if the refractive index is set to 1.8 for an optical path length L2, the physical film thickness for the optical path length L2 is set to 210 to 250 nm. Thus, a transparent insulating film 22 is designed to be thinner in the second region D2 than in the first region D1 so that the difference in the physical film thickness between the optical path lengths L5 and L4 falls within the range of 78 nm (inclusive) to 118 nm (inclusive).

As a modification of the fifth embodiment, three or more steps can be provided or the thickness of the transparent insulating film 22 can continuously be changed to have a convex shape, as in the third or fourth embodiment.

Other embodiments will be described below.

As exemplified in Fig. 11E, a pixel 15 can have a rectangular shape, and a second electrode 13 (or a light emitting region B) of each sub-pixel can include a first region C1, a second region C2, and a third region C2'. An optical path length L1 in the first region C1, an optical path length L2 in the second region C2, and an optical path length L2' in the third region C2' can have a relationship of L2 >L2'>L1.

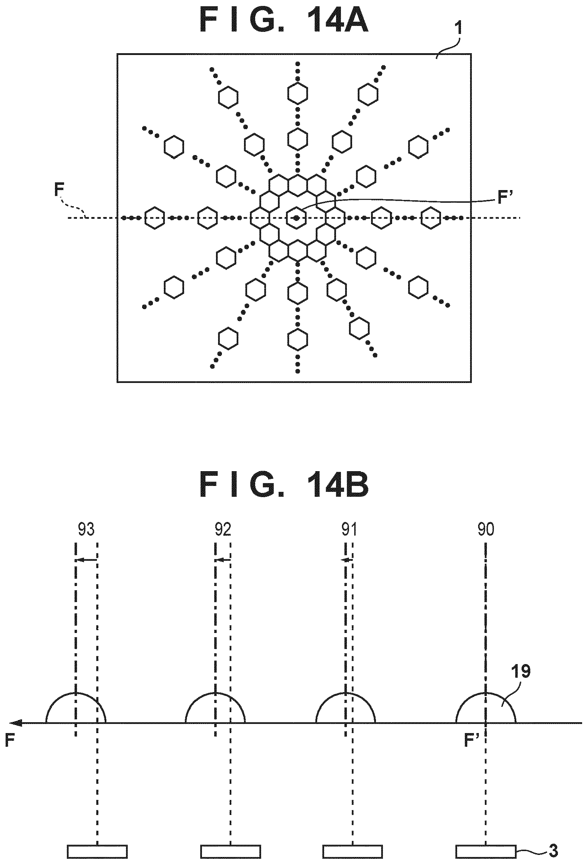

Fig. 14 exemplifies the relative positions of an optical member 19 and another component (reflective film 11) of a sub-pixel 3. Fig. 14A is a plan view of a display region 1 of a light emitting device LE. Fig. 14B is a schematic sectional view taken along a line F - F' in Fig. 14A. Fig. 14B shows the relationship among the position of a light emitting element in the display region and the relative positions of the center of the optical member 19 and the center of the reflective film 11 (or the light emitting region B). At the central position of the display region 1, the center of the optical member 19 coincides with the center of the reflective film 11 (or the light emitting region B). On the other hand, as denoted by reference numerals 90, 91, 92, and 93, as the distance from the center of the display region 1 is longer, the distance between the center of the optical member 19 and the center of the reflective film 11 (or the light emitting region B) is longer.

Note that a change in the distance between the center of the optical member 19 and the center of the reflective film 11 (or the light emitting region B) in Fig. 14B is merely an example. For example, as the distance from the center of the display region 1 is longer, the distance between the center of the optical member 19 and the center of the reflective film 11 (or the light emitting region B) may be shorter. The distance between the center of the optical member 19 and the center of the reflective film 11 (or the light emitting region B) can be designed to macroscopically, continuously change in accordance with the position in the display region 1. The distance need only macroscopically, continuously change, and may be changed for each light emitting element or changed stepwise for every a plurality of light emitting elements. Alternatively, the form in which the distance is changed for each light emitting element and the form in which the distance is changed stepwise for every a plurality of light emitting elements may be combined. This can control, in the display region, the angle of light emitted from the optical member 19.

The light emitting device according to the present invention can be applied to a display device or an illumination device. Alternatively, the light emitting device according to the present invention may be applied to the exposure light source of an electrophotographic image forming device or the backlight of a liquid crystal display device.

The display device can include an image input unit for receiving image information from an image input device such as an area CCD, a linear CCD, or a memory card, an information processing unit for processing the image information, a display unit, and a display control unit for displaying, on the display unit, an image generated by the information processing unit. The display unit can be formed by the light emitting device according to the present invention.

In addition, the light emitting device according to the present invention may be applied to an image sensing device or a printer. A display unit included in the image sensing device or the printer can have a touch panel function. The driving type of the touch panel function can be an infrared type, a capacitance type, a resistive film type, an electromagnetic induction type, or another type.

Application examples of the above-described light emitting device will exemplarily be described below.

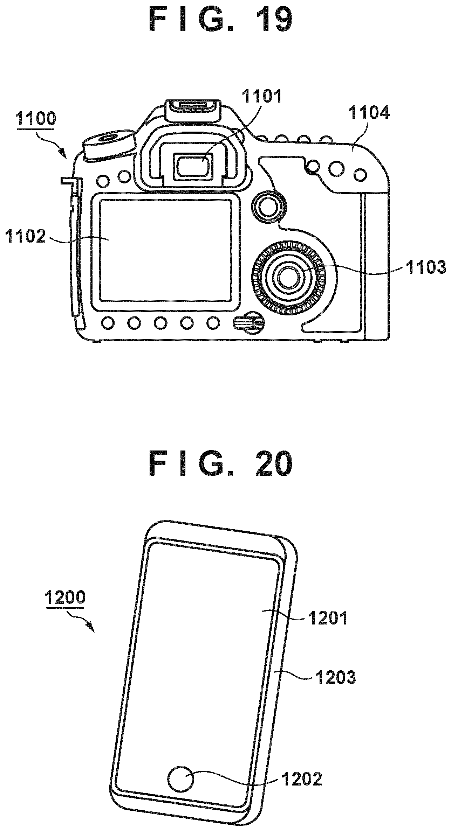

Fig. 19 exemplarily shows the arrangement of an image sensing device 1100 in which the light emitting device according to each of the above-described embodiments is incorporated. The image sensing device 1100 can include a viewfinder 1101, a rear display 1102, an operation unit 1103, and a housing 1104. The image sensing device may also be called a camera. Alternatively, the image sensing device may be incorporated in an electronic apparatus such as a computer. The light emitting device according to each of the above-described embodiments can be applied to the viewfinder 1101 as a display unit. Not only an image captured by an image sensor but also environment information, image sensing instructions, and the like may be displayed on the viewfinder 1101. Examples of the environment information are the intensity and direction of external light, the moving velocity of an object, and the possibility that an object is covered with an obstacle.

The image sensing device 1100 includes an optical unit (not shown). This optical unit has a plurality of lenses, and forms an image on an image sensor (not shown) that receives light having passed through the optical unit and is accommodated in the housing 1104. The focal points of the plurality of lenses can be adjusted by adjusting the relative positions. This operation can also automatically be performed.

The light emitting device according to each of the above-described embodiments may be applied to a display unit of an electronic apparatus. At this time, the display unit can have both a display function and an operation function. Examples of the portable terminal are a portable phone such as a smartphone, a tablet, and a head mounted display.

Fig. 20 is a schematic view showing an example of an electronic apparatus in which the light emitting device according to each of the above-described embodiments is incorporated. An electronic apparatus 1200 includes a display unit 1201, an operation unit 1202, and a housing 1203. The housing 1203 can accommodate a circuit, a printed board having this circuit, a battery, and a communication unit. The operation unit 1202 can be a button or a touch-panel-type reaction unit. The operation unit 1202 can also be a biometric authentication unit that performs unlocking or the like by authenticating the fingerprint. The portable apparatus including the communication unit can also be regarded as a communication apparatus. The light emitting device according to each of the above-described embodiments can be applied to the display unit 1201.

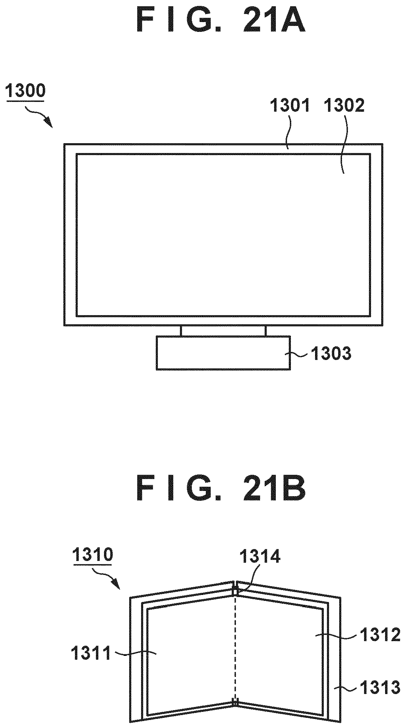

Figs. 21A and 21B show application examples of the light emitting device according to each of the above-described embodiments. Fig. 21A shows a display device such as a television monitor or a PC monitor. A display device 1300 includes a frame 1301 and a display unit 1302. The light emitting device according to each of the above-described embodiments can be applied to the display unit 1302. The display device 1300 can include a base 1303 that supports the frame 1301 and the display unit 1302. The base 1303 is not limited to the form shown in Fig. 21A. For example, the lower side of the frame 1301 may also function as the base 1303. In addition, the frame 1301 and the display unit 1302 can be bent. The radius of curvature in this case can be 5,000 mm (inclusive) to 6,000 mm (inclusive).

Fig. 21B shows another application example of the light emitting device according to each of the above-described embodiments. A display device 1310 shown in Fig. 21B can be folded, and is a so-called foldable display device. The display device 1310 includes a first display unit 1311, a second display unit 1312, a housing 1313, and a bending point 1314. The light emitting device according to each of the above-described embodiments can be applied to each of the first display unit 1311 and the second display unit 1312. The first display unit 1311 and the second display unit 1312 can also be one seamless display device. The first display unit 1311 and the second display unit 1312 can be divided by the bending point. The first display unit 1311 and the second display unit 1312 can display different images, and can also display one image together.

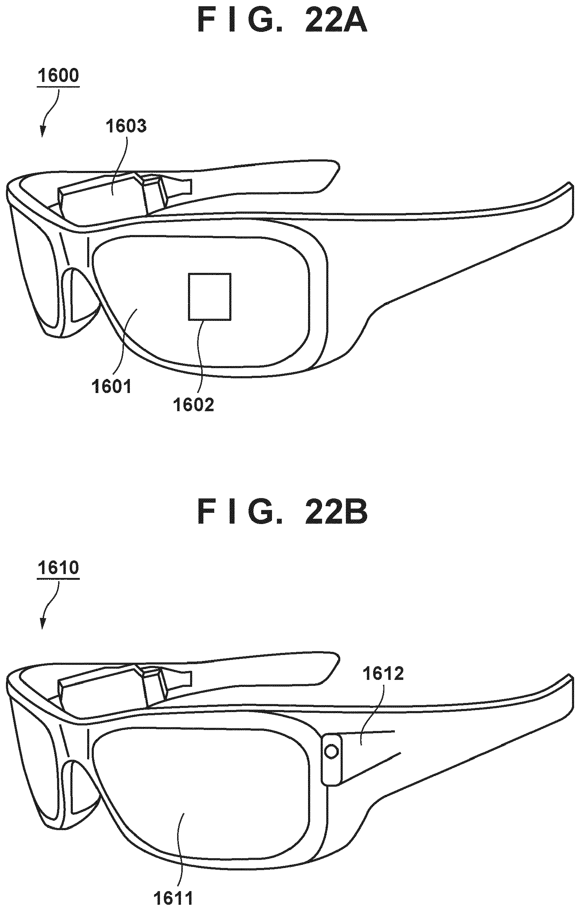

Figs. 22A and 22B show other examples of the electronic apparatus in which the light emitting device according to each of the above-described embodiments is incorporated. The light emitting device according to each of the above-described embodiments can be applied to a wearable device such as smartglasses, an HMD, or a smart contact lens. An image sensing display device used for such application examples includes an image sensing device capable of photoelectrically converting visible light and a display device capable of emitting visible light.

Glasses 1600 (smartglasses) according to one application example will be described with reference to Fig. 22A. An image sensing device 1602 such as a CMOS sensor or an SPAD is provided on the surface side of a lens 1601 of the glasses 1600. In addition, the light emitting device according to each of the above-described embodiments is provided on the back surface side of the lens 1601.

The glasses 1600 further include a control device 1603. The control device 1603 functions as a power supply that supplies electric power to the image sensing device 1602 and the display device according to each of the above-described embodiments. In addition, the control device 1603 controls the operations of the image sensing device 1602 and the display device. An optical system configured to condense light to the image sensing device 1602 is formed on the lens 1601.

Glasses 1610 (smartglasses) according to one application example will be described with reference to Fig. 22B. The glasses 1610 include a control device 1612, and an image sensing device corresponding to the image sensing device 1602 and the display device are mounted on the control device 1612. The image sensing device in the control device 1612 and an optical system configured to project light emitted from the display device are formed in a lens 1611, and an image is projected to the lens 1611. The control device 1612 functions as a power supply that supplies electric power to the image sensing device and the display device, and controls the operations of the image sensing device and the display device. The control device may include a line-of-sight detection unit that detects the line of sight of a wearer. The detection of a line of sight may be done using infrared rays. An infrared ray emitting unit emits infrared rays to an eyeball of the user who is gazing at a displayed image. An image sensing unit including a light receiving element detects reflected light of the emitted infrared rays from the eyeball, thereby obtaining a captured image of the eyeball. A reduction unit for reducing light from the infrared ray emitting unit to the display unit in a planar view is provided, thereby reducing deterioration of image quality.

The line of sight of the user to the displayed image is detected from the captured image of the eyeball obtained by sensing the infrared rays. An arbitrary known method can be applied to the line-of-sight detection using the captured image of the eyeball. As an example, a line-of-sight detection method based on a Purkinje image obtained by reflection of irradiation light by a cornea can be used.

More specifically, line-of-sight detection processing based on pupil center corneal reflection is performed. Using pupil center corneal reflection, a line-of-sight vector representing the direction (rotation angle) of the eyeball is calculated based on the image of the pupil and the Purkinje image included in the captured image of the eyeball, thereby detecting the line-of-sight of the user.

The light emitting device according to the embodiment of the present invention can include an image sensing device including a light receiving element, and control a displayed image of the display device based on the line-of-sight information of the user from the image sensing device.

More specifically, the display device decides a first visual field region at which the user is gazing and a second visual field region other than the first visual field region based on the line-of-sight information. The first visual field region and the second visual field region may be decided by the control device of the display device, or those decided by an external control device may be received. In the display region of the display device, the display resolution of the first visual field region may be controlled to be higher than the display resolution of the second visual field region. That is, the resolution of the second visual field region may be lower than that of the first visual field region.

In addition, the display region includes a first display region and a second display region different from the first display region, and a region of higher priority is decided from the first display region and the second display region based on line-of-sight information. The first display region and the second display region may be decided by the control device of the display device, or those decided by an external control device may be received. The resolution of the region of higher priority may be controlled to be higher than the resolution of the region other than the region of higher priority. That is, the resolution of the region of relatively low priority may be low.

Note that AI may be used to decide the first visual field region or the region of higher priority. The AI may be a model configured to estimate the angle of the line of sight and the distance to a target ahead the line of sight from the image of the eyeball using the image of the eyeball and the direction of actual viewing of the eyeball in the image as supervised data. The AI program may be held by the display device, the image sensing device, or an external device. If the external device holds the AI program, it is transmitted to the display device via communication.

When performing display control based on line-of-sight detection, smartglasses further including an image sensing device configured to sense the image of the outside can preferably be applied. The smartglasses can display the sensed outside image information in real time.

The present disclosure includes the following arrangement.

1. A light emitting device in which a reflective film, a first electrode, an organic film including a light emitting layer, a second electrode, and an optical member are arranged in this order on a principal surface of a substrate and a bank configured to cover a peripheral portion of the first electrode is provided to define a light emitting region,

wherein the reflective film, the first electrode, the organic film, and the second electrode form a resonator structure configured to resonate, between the reflective film and the second electrode, light generated in the organic film,
in the light emitting region, an upper surface of the reflective film is flatter than the first electrode, and
the resonator structure has a plurality of different optical path lengths.

2. The device according to arrangement 1, wherein the light emitting region includes a first region and a second region outside the first region, and an optical path length in the second region is longer than an optical path length in the first region.

3. The device according to arrangement 1 or 2, wherein a difference between a physical film thickness that defines the optical path length in the second region and a physical film thickness that defines the optical path length in the first region falls within a range of not less than 4 nm and not more than 53 nm.

4. The device according to arrangement 2, wherein an area of the first region falls within a range of not less than 10% and not more than 90% of a sum of the area of the first region and an area of the second region.

5. The device according to arrangement 2, wherein an area of the first region is smaller than an area of the second region.

6. The device according to any one of arrangements 2, 4 and 5, wherein an area of the first region falls within a range of not less than 10% and not more than 50% of a sum of the area of the first region and an area of the second region.

7. The device according to any one of arrangements 1 to 6, wherein the light emitting region includes a first region and a second region outside the first region, and an optical path length in the second region is shorter than an optical path length in the first region.

8. The device according to arrangement 7, wherein a difference between a physical film thickness that defines the optical path length in the first region and a physical film thickness that defines the optical path length in the second region falls within a range of not less than 78 nm and not more than 118 nm.

9. The device according to any one of arrangements 1 to 8, wherein the reflective film, the first electrode, the organic film, and the second electrode are arranged to define the plurality of different optical path lengths.

10. A light emitting device in which a first electrode, an organic film including a light emitting layer, a second electrode, and an optical member are arranged in this order on a principal surface of a substrate and which has a resonator structure configured to resonate light of the light emitting layer,

> wherein the first electrode includes a first region including a central portion of the first electrode in a planar view and a second region arranged outside the first region in the planar view, and
> an optical path length of the resonator structure in the second region is longer than an optical path length of the resonator structure in the first region.

11. The device according to arrangement 10, wherein a reflective film is provided between the principal surface of the substrate and the first electrode.

12. The device according to arrangement 10 or 11, wherein an area of the first region falls within a range of not less than 10% and not more than 90% of a sum of the area of the first region and an area of the second region.

13. The device according to any one of arrangements 10 to 12, wherein an area of the first region is smaller than an area of the second region.

14. The device according to any one of arrangements 10 to 13, wherein an area of the first region falls within a range of not less than 10% and not more than 50% of a sum of the area of the first region and an area of the second region.

15. The device according to any one of arrangements 1 to 14, wherein the optical member includes a collimator.

16. The device according to any one of arrangements 1 to 15, wherein the second electrode includes a plurality of regions, and distances between lower surfaces of the plurality of regions and an upper surface of the reflective film are different from each other.

17. The device according to arrangement 16, wherein the second electrode includes at least one step.

18. The device according to arrangement 17, wherein the organic film includes at least one step, and the at least one step of the second electrode follows the at least one step of the organic film.

19. The device according to arrangement 18, wherein the first electrode includes at least one step, and the at least one step of the organic film follows the at least one step of the first electrode.

20. The device according to arrangement 19, wherein a transparent insulating film is provided between the reflective film and the first electrode, the transparent insulating film includes at least one step, and the at least one step of the first electrode follows the at least one step of the transparent insulating film.

21. The device according to arrangement 16, wherein the plurality of regions include a first region having a circular shape and a second region having a ring shape surrounding the first region.

22. The device according to arrangement 21, wherein the light emitting region has a polygonal shape.

23. The device according to arrangement 16, wherein the plurality of regions include a first region having a rectangular shape and a second region having a frame shape surrounding the first region.

24. The device according to arrangement 7, wherein the second electrode has one of a curved surface and an oblique surface.

25. The device according to arrangement 24, wherein the organic film has one of a curved surface and an oblique surface, and the oblique surface of the second electrode follows one of the curved surface and the oblique surface of the organic film.

26. The device according to arrangement 25, wherein the first electrode has one of a curved surface and an oblique surface, and one of the curved surface and the oblique surface of the organic film follows one of the curved surface and the oblique surface of the first electrode.

27. The device according to arrangement 20, wherein the transparent insulating film has one of a curved surface and an oblique surface, and one of a curved surface and an oblique surface of the first electrode follows one of the curved surface or the oblique surface of the transparent insulating film.

28. The device according to arrangement 20, wherein

a first sub-pixel including the reflective film, the transparent insulating film, the first electrode, the organic film, and the second electrode and a second sub-pixel including the reflective film, the transparent insulating film, the first electrode, the organic film, and the second electrode are provided, and
a thickness of the transparent insulating film of the first sub-pixel is different from a thickness of the transparent insulating film of the second sub-pixel.

29. The device according to any one of arrangements 1 to 28, wherein an upper surface of the reflective film is parallel to the principal surface of the substrate in the light emitting region.

30. The device according to any one of arrangements 1 to 29, wherein the organic film generates white light.

31. A display device comprising a light emitting device defined in any one of arrangements 1 to 30.

32. An image sensing device comprising an optical unit including a plurality of lenses, an image sensor configured to receive light having passed through the optical unit, and a display unit configured to display an image, wherein the display unit includes a light emitting device defined in any one of arrangements 1 to 30.

33. An electronic apparatus comprising a housing provided with a display unit, and a communication unit provided in the housing and configured to perform external communication, wherein the display unit includes a light emitting device defined in any one of arrangements 1 to 30.

While the present invention has been described with reference to exemplary embodiments, it is to be understood that the invention is not limited to the disclosed exemplary embodiments. The scope of the following claims is to be accorded the broadest interpretation so as to encompass all such modifications and equivalent structures and functions.

**Claims**

1. A light emitting device in which a reflective film, a first electrode, an organic film including a light emitting layer, a second electrode, and an optical member are arranged in this order on a principal surface of a substrate and a bank configured to cover a peripheral portion of the first electrode is provided to define a light emitting region,

wherein the reflective film, the first electrode, the organic film, and the second electrode form a resonator structure configured to resonate, between the reflective film and the second electrode, light generated in the organic film,
in the light emitting region, an upper surface of the reflective film is flatter than the first electrode, and
the resonator structure has a plurality of different optical path lengths.

2. The device according to claim 1, wherein the light emitting region includes a first region and a second region outside the first region, and an optical path length in the second region is longer than an optical path length in the first region.

3. The device according to claim 2, wherein a difference between a physical film thickness that defines the optical path length in the second region and a physical film thickness that defines the optical path length in the first region falls within a range of not less than 4 nm and not more than 53 nm.

4. The device according to claim 2, wherein an area of the first region falls within a range of not less than 10% and not more than 90% of a sum of the area of the first region and an area of the second region.

5. The device according to claim 2, wherein an area of the first region is smaller than an area of the second region.

6. The device according to claim 2, wherein an area of the first region falls within a range of not less than 10% and not more than 50% of a sum of the area of the first region and an area of the second region.

7. The device according to claim 1, wherein the light emitting region includes a first region and a second region outside the first region, and an optical path length in the second region is shorter than an optical path length in the first region.

8. The device according to claim 7, wherein a difference between a physical film thickness that defines the optical path length in the first region and a physical film thickness that defines the optical path length in the second region falls within a range of not less than 78 nm and not more than 118 nm.

9. The device according to claim 1, wherein the reflective film, the first electrode, the organic film, and the second electrode are arranged to define the plurality of different optical path lengths.

10. A light emitting device in which a first electrode, an organic film including a light emitting layer, a second electrode, and an optical member are arranged in this order on a principal surface of a substrate and which has a resonator structure configured to resonate light of the light emitting layer,

   wherein the first electrode includes a first region including a central portion of the first electrode in a planar view and a second region arranged outside the first region in the planar view, and
   an optical path length of the resonator structure in the second region is longer than an optical path length of the resonator structure in the first region.

11. The device according to claim 10, wherein a reflective film is provided between the principal surface of the substrate and the first electrode.

12. The device according to claim 10, wherein an area of the first region falls within a range of not less than 10% and not more than 90% of a sum of the area of the first region and an area of the second region.

13. The device according to claim 10, wherein an area of the first region is smaller than an area of the second region.

14. The device according to claim 10, wherein an area of the first region falls within a range of not less than 10% and not more than 50% of a sum of the area of the first region and an area of the second region.

15. The device according to claim 1, wherein the optical member includes a collimator.

16. The device according to claim 1, wherein the second electrode includes a plurality of regions, and distances between lower surfaces of the plurality of regions and an upper surface of the reflective film are different from each other.

17. The device according to claim 16, wherein the second electrode includes at least one step.

18. The device according to claim 17, wherein the organic film includes at least one step, and the at least one step of the second electrode follows the at least one step of the organic film.

19. The device according to claim 18, wherein the first electrode includes at least one step, and the at least one step of the organic film follows the at least one step of the first electrode.

20. The device according to claim 19, wherein a transparent insulating film is provided between the reflective film and the first electrode, the transparent insulating film includes at least one step, and the at least one step of the first electrode follows the at least one step of the transparent insulating film.

21. The device according to claim 16, wherein the plurality of regions include a first region having a circular shape and a second region having a ring shape surrounding the first region.

22. The device according to claim 21, wherein the light emitting region has a polygonal shape.

23. The device according to claim 16, wherein the plurality of regions include a first region having a rectangular shape and a second region having a frame shape surrounding the first region.

24. The device according to claim 7, wherein the second electrode has one of a curved surface and an oblique surface.

25. The device according to claim 24, wherein the organic film has one of a curved surface and an oblique surface, and the oblique surface of the second electrode follows one of the curved surface and the oblique surface of the organic film.

26. The device according to claim 25, wherein the first electrode has one of a curved surface and an oblique surface, and one of the curved surface and the oblique surface of the organic film follows one of the curved surface and the oblique surface of the first electrode.

27. The device according to claim 20, wherein the transparent insulating film has one of a curved surface and an oblique surface, and one of a curved surface and an oblique surface of the first electrode follows one of the curved surface or the oblique surface of the transparent insulating film.

28. The device according to claim 20, wherein

a first sub-pixel including the reflective film, the transparent insulating film, the first electrode, the organic film, and the second electrode and a second sub-pixel including the reflective film, the transparent insulating film, the first electrode, the organic film, and the second electrode are provided, and
a thickness of the transparent insulating film of the first sub-pixel is different from a thickness of the transparent insulating film of the second sub-pixel.

29. The device according to claim 1, wherein an upper surface of the reflective film is parallel to the principal surface of the substrate in the light emitting region.

30. The device according to any one of claims 1 to 29, wherein the organic film generates white light.

31. A display device comprising a light emitting device defined in any one of claims 1 to 30.

32. An image sensing device comprising an optical unit including a plurality of lenses, an image sensor configured to receive light having passed through the optical unit, and a display unit configured to display an image,
wherein the display unit includes a light emitting device defined in any one of claims 1 to 30.

33. An electronic apparatus comprising a housing provided with a display unit, and a communication unit provided in the housing and configured to perform external communication,
wherein the display unit includes a light emitting device defined in any one of claims 1 to 30.

# FIG. 1

LE

# FIG. 2

# FIG. 3

# F I G. 4A

C2    C1    C2

L1

13

12

L2    L2

16

201    23

22

200    11

100

B

# F I G. 4B

C2    C1    C2

L1

13

12

L2    L2

16

23

22

201    200    11

100

B

# F I G. 5

# F I G. 6

# FIG. 7

C8  C7  C6  C7  C8

L7  L6  L8

13
12
16
23
22
11
100

B

# FIG. 8

L11  L10  L9

13
12
16
23
22
11

B

# F I G. 9

# F I G. 10

# FIG. 11A

C1 C2

11

B

# FIG. 11B

C4
C3
15
C2
C1
C5
C6

# FIG. 11C

C4
15 C3
C2
C1
D1
D2
C5
C6

# FIG. 11D

15
11
C1 C3 C5
B
19 C2 C4 C6

# FIG. 11E

C2 C4 C6
15 C1 C3 C5
11
B
19 C2' C4' C6'

# FIG. 11F

15 C1 C3 C5 D1
11
B
19
C2 C4 C6 D2

F I G. 12A

F I G. 12B

# F I G. 13

# F I G. 14A

# F I G. 14B

# F I G. 15

# F I G. 16

# F I G. 17

# F I G. 18

S11

~23
~22
~11
~100

S12

23
~16
~22
~11
~100

# F I G. 19

# F I G. 20

# F I G. 21A

1300

1301 1302

1303

# F I G. 21B

1310

1314

1311

1312

1313

# F I G. 22A

# F I G. 22B

Europäisches
Patentamt

European
Patent Office

Office européen
des brevets

# EUROPEAN SEARCH REPORT

**Application Number**

EP 22 21 1089

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2005/280364 A1 (OMURA TETSUJI [JP] ET AL) 22 December 2005 (2005-12-22) | 1-14, 16-20, 24-27, 29-31 | INV. H10K59/124 H10K59/80 |
| Y | * paragraphs [0013], [0015], [0016], [0036], [0037], [0041], [0044], [0045], [0050], [0052], [0053], [0054], [0056], [0057], [0058], [0060] - [0064] * | 15, 21-23, 28,32,33 | |
| Y | WO 2021/171857 A1 (SONY SEMICONDUCTOR SOLUTIONS CORP [JP]) 2 September 2021 (2021-09-02) * paragraphs [0042], [0048], [0118], [0119], [0122], [0125], [0128], [0129] * | 15,28, 32,33 | |
| Y | US 2021/013453 A1 (MATSUDA YOJIRO [JP] ET AL) 14 January 2021 (2021-01-14) * paragraphs [0089], [0090]; figure 12 * | 15 | |
| Y | US 2018/130852 A1 (HSU MING HUNG [CN]) 10 May 2018 (2018-05-10) * paragraphs [0038], [0041], [0054], [0055], [0059], [0060], [0062]; figures 4-6 * | 21-23 | **TECHNICAL FIELDS SEARCHED (IPC)** H10K |
| A | US 2009/072693 A1 (COK RONALD S [US] ET AL) 19 March 2009 (2009-03-19) * paragraph [0036]; figure 1 * | 1-33 | |
| A | JP 2007 234581 A (SONY CORP) 13 September 2007 (2007-09-13) * paragraph [0010]; figures 3-5,15,16,18 * | 1-33 | |
| A | US 2021/014393 A1 (HINATA SHOMA [JP] ET AL) 14 January 2021 (2021-01-14) * paragraphs [0092] - [0100]; figures 3a,,9A-9C * | 1-33 | |

The present search report has been drawn up for all claims

| Place of search | Date of completion of the search | Examiner |
|---|---|---|
| The Hague | 21 April 2023 | Faou, Marylène |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

............................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 22 21 1089

This annex lists the patent family members relating to the patent documents cited in the above-mentioned European search report.
The members are as contained in the European Patent Office EDP file on
The European Patent Office is in no way liable for these particulars which are merely given for the purpose of information.

21-04-2023

| Patent document cited in search report | | Publication date | Patent family member(s) | | Publication date |
|---|---|---|---|---|---|
| US 2005280364 | A1 | 22-12-2005 | CN | 1717135 A | 04-01-2006 |
| | | | KR | 20060046476 A | 17-05-2006 |
| | | | TW | I272039 B | 21-01-2007 |
| | | | US | 2005280364 A1 | 22-12-2005 |
| WO 2021171857 | A1 | 02-09-2021 | CN | 115066979 A | 16-09-2022 |
| | | | EP | 4092454 A1 | 23-11-2022 |
| | | | JP | WO2021171857 A1 | 02-09-2021 |
| | | | KR | 20220146436 A | 01-11-2022 |
| | | | TW | 202137598 A | 01-10-2021 |
| | | | US | 2023097317 A1 | 30-03-2023 |
| | | | WO | 2021171857 A1 | 02-09-2021 |
| US 2021013453 | A1 | 14-01-2021 | CN | 112216730 A | 12-01-2021 |
| | | | EP | 3764399 A1 | 13-01-2021 |
| | | | JP | 2021015732 A | 12-02-2021 |
| | | | US | 2021013453 A1 | 14-01-2021 |
| US 2018130852 | A1 | 10-05-2018 | CN | 104900684 A | 09-09-2015 |
| | | | EP | 3308402 A1 | 18-04-2018 |
| | | | JP | 6779791 B2 | 04-11-2020 |
| | | | JP | 2018518792 A | 12-07-2018 |
| | | | KR | 20170005027 A | 11-01-2017 |
| | | | US | 2017110519 A1 | 20-04-2017 |
| | | | US | 2018130852 A1 | 10-05-2018 |
| | | | WO | 2016197582 A1 | 15-12-2016 |
| US 2009072693 | A1 | 19-03-2009 | CN | 101821851 A | 01-09-2010 |
| | | | EP | 2201604 A1 | 30-06-2010 |
| | | | JP | 5231556 B2 | 10-07-2013 |
| | | | JP | 2010539653 A | 16-12-2010 |
| | | | KR | 20100080801 A | 12-07-2010 |
| | | | US | 2009072693 A1 | 19-03-2009 |
| | | | US | 2010231485 A1 | 16-09-2010 |
| | | | WO | 2009038704 A1 | 26-03-2009 |
| JP 2007234581 | A | 13-09-2007 | CN | 101013745 A | 08-08-2007 |
| | | | JP | 4645587 B2 | 09-03-2011 |
| | | | JP | 2007234581 A | 13-09-2007 |
| | | | KR | 20070079946 A | 08-08-2007 |
| | | | TW | I376976 B | 11-11-2012 |
| | | | US | 2008143649 A1 | 19-06-2008 |
| | | | US | 2010265223 A1 | 21-10-2010 |
| US 2021014393 | A1 | 14-01-2021 | CN | 112216806 A | 12-01-2021 |
| | | | EP | 3764400 A2 | 13-01-2021 |

EPO FORM P0459

For more details about this annex : see Official Journal of the European Patent Office, No. 12/82

**page 1 of 2**

## ANNEX TO THE EUROPEAN SEARCH REPORT
## ON EUROPEAN PATENT APPLICATION NO.

EP 22 21 1089

This annex lists the patent family members relating to the patent documents cited in the above-mentioned European search report.
The members are as contained in the European Patent Office EDP file on
The European Patent Office is in no way liable for these particulars which are merely given for the purpose of information.

21-04-2023

| Patent document cited in search report | Publication date | Patent family member(s) | | Publication date |
|---|---|---|---|---|
| | | EP 3996144 A1 | | 11-05-2022 |
| | | US 2021014393 A1 | | 14-01-2021 |

EPO FORM P0459

For more details about this annex : see Official Journal of the European Patent Office, No. 12/82

page 2 of 2

**EP 4 195 901 A1**

**Patent documents cited in the description**

- JP 2011054526 A